# EUROPEAN PATENT APPLICATION

(11) **EP 2 688 204 A1**
(43) Date of publication of application: **22.01.2014**
(21) Application number: 11875909.1
(22) Date of filing: 14.11.2011
(51) Int. Cl.: H03F 3/70, H03F 3/45, H03G 3/10

(54) **ELECTRIC CHARGE DETECTION CIRCUIT**

(71) Applicant: Fuji Electric Co., Ltd., Kawasaki-shi Kanagawa 210-9530 (JP)
(72) Inventor: SUZUKI, Takeshi, Kawasaki-shi Kanagawa 210-9530 (JP); MATSUO, Naoyuki, Kawasaki-shi Kanagawa 210-9530 (JP); KISHIRO, Masami, Kawasaki-shi Kanagawa 210-9530 (JP)
(74) Representative: MERH-IP Matias Erny Reichl Hoffmann
(86) International application number: PCT/JP2011/006349
(87) International publication number: WO 2013/072950

(57) **Abstract**

Provided is an electric charge detection circuit that enables easily performing gain adjustment on the input side of a differential amplifier circuit. Ends on one side of physical quantity detection sensors 21, 22 formed of any of an electric charge generation-type sensor and a capacitance change-type sensor are connected to negative electrode input terminals of a differential amplifier circuit 1, and ends on the other side are connected to positive electrode input terminals of the differential amplifier circuit 1. A feedback resistor Rf and a feedback capacitor Cf are connected in parallel between the negative electrode input terminal and an output terminal of the differential amplifier circuit 1, and a cancel resistor Rc and a cancel capacitor Cc are connected in parallel between a reference voltage and the positive electrode input terminal of the differential amplifier circuit 1. Drain voltage adjustment circuits 12, 13 are provided that adjust the drain voltage of at least one of two field effect transistors FET 1, FET 2 to which positive and negative differential inputs of the differential amplifier circuit 1 are individually inputted. Gain adjustment of at least one of the positive and negative differential inputs is thus enabled.

## Description

### BACKGROUND OF THE INVENTION

### 1. Field of the Invention

The present invention relates to an electric charge detection circuit that detects electric charge in an electric charge generation-type sensor or capacitance change-type sensor such as a pressure sensor, a microphone, an acceleration sensor, an angular velocity sensor, a strain gauge or the like.

### 2. Description of the Related Art

Typical examples of electric charge generation-type sensors include, for instance, strain gauges and acceleration sensors that utilize a piezoelectric element of an insulator. Examples of sensors that detect changes in capacitance include, for instance, acceleration sensors in which a weight is held on a beam, and a fixed electrode is held in the vicinity of a side of the weight, and capacitance between the weight and the fixed electrode is measured. All these sensors measure small electric charges, and utilize a charge amplifier as an electric charge detection circuit for electric charge-voltage conversion.

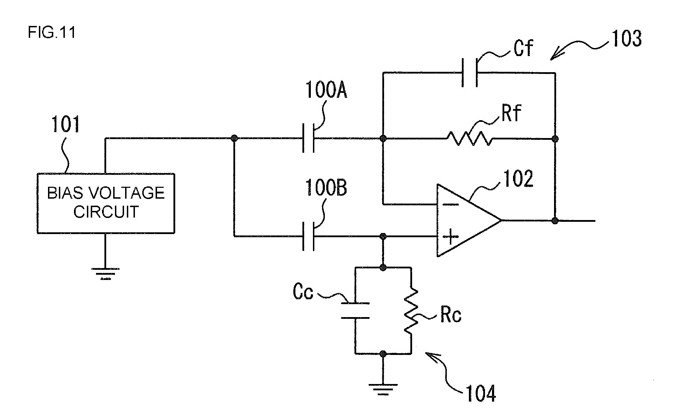

An in-phase signal (common-mode signal) can be removed by using one differential amplifier circuit, as disclosed in Japanese Patent Application Publication Nos. 2001-326548 and 2003-258577, with a view to improving SN. In a case where the conventional example disclosed in Japanese Patent Application Publication Nos. 2001-326548 and 2003-258577 is applied to a capacitance change-type sensor to which bias voltage is supplied, one end of each of two variable-capacitance sensors 100A and 100B that make up a pair is connected to a bias voltage circuit 101, and the other end is connected to a negative electrode input terminal and a positive electrode input terminal of a differential amplifier circuit 102, as illustrated in Fig. 11.

A feedback circuit 103, in which a feedback capacitor Cf and a feedback resistor Rf are connected in parallel, is connected between the negative electrode terminal and the output terminal of the differential amplifier circuit 102, a cancel circuit 104, in which a cancel capacitor Cc and a cancel resistor Rc are connected in parallel, is connected between ground and a connection point of the variable-capacitance sensor 100B and the positive electrode input terminal of the differential amplifier circuit 102, such that common-mode noise is canceled by this cancel circuit 104.

In the conventional example disclosed in Japanese Patent Application Publication Nos. 2001-326548 and 2003-258577, an in-phase signal is removed by resorting to one differential amplifier circuit. The degree to which an in-phase signal can be actually removed is assessed next.

Firstly, the feedback capacitor Cf and the cancel capacitor Cc must have identical electrostatic capacitance, but an error of about 5 to 10% in electrostatic capacitance arises when manufacturing variability is accounted for. A comparable variability in the electric charge generation-type sensor or capacitance change-type sensor on the input side can also be expected, and hence a signal removal rate of about 20 dB is expected. That is, there remains an in-phase signal of about 1/10.

A removal rate of this order is sufficient in some instances, but in the case of a high-sensitivity sensor the gain after a charge amplifier may exceed a hundredfold gain and the circuit may saturate, and the dynamic range is reduced as a result. This constitutes an unresolved problem.

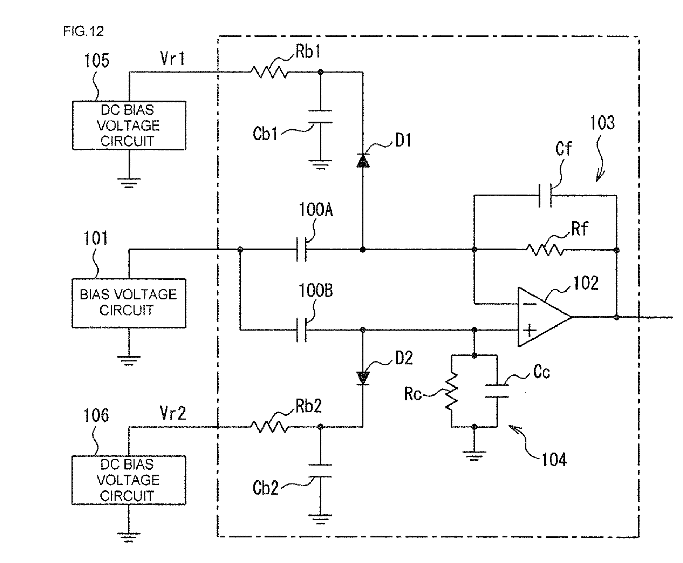

Therefore, the negative gain and positive gain in the negative electrode input terminal and the positive electrode input terminal of the differential amplifier circuit 102 must be finely adjusted. Fig. 12 illustrates a conceivable configuration for accomplishing this gain adjustment. Specifically, the anode of a variable-capacitance diode D1 is connected to the negative electrode input terminal of the differential amplifier circuit 102, and a DC bias voltage circuit 105 is connected to the cathode of the variable-capacitance diode D1 via a low pass filter that comprises a resistor Rb1 and a capacitor Cb1. The anode of a variable-capacitance diode D2 is connected to the positive electrode input terminal of the differential amplifier circuit 102, and a DC bias voltage circuit 106 is connected to the cathode of the variable-capacitance diode D2 via a low pass filter that comprises a resistor Rb2 and a capacitor Cb2.

As illustrated in Fig. 12, the variable-capacitance diodes D1 and D2 are connected, and for instance a reverse bias voltage Vr2 of the variable-capacitance diode D2 is fixed to a constant value while a reverse bias voltage Vr1 of the variable-capacitance diode D1 is set to be variable; the input capacitance of the negative electrode input terminal and the positive electrode input terminal of the differential amplifier circuit 102 is adjusted thereby, and fine gain adjustments become in principle possible as a result.

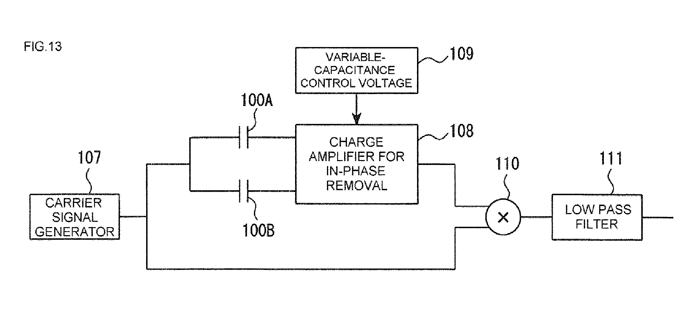

The electric charge detection circuit illustrated in Fig. 12 is used in a variable capacitance-type acceleration sensor, and a carrier signal generator 107 that generates a 50 kHz carrier signal is connected to one respective end of the sensors of the pair of acceleration sensors 100A and 100B, as illustrated in Fig. 13. A charge amplifier 108 that utilizes the variable-capacitance diodes D1 and D2 illustrated in Fig. 12 is connected to the other ends of the acceleration sensors 100A and 100B, and there is connected a variable-capacitance control voltage generation circuit 109 that variably controls the electrostatic capacitance of the variable-capacitance diodes D1 and D2 of the charge amplifier 108. A detection output of the charge amplifier 108 and a carrier signal outputted by the carrier signal generator 107 are multiplied by a multiplier 110, as a result of which there is decoded the output of the charge amplifier that samples the acceleration sensors 100A and 100B with the carrier signal. In a conceivable instance, a system can be configured wherein a low-frequency acceleration detection value not higher than 1 kHz is obtained by causing this decoded signal to pass through a low pass filter 111 the cutoff frequency whereof is set to 1 kHz or less.

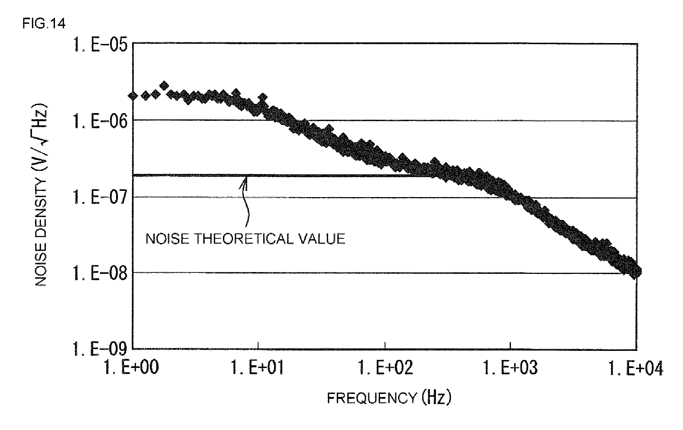

In this case, a value is observed wherein the frequency dependence of noise voltage exceeds a theoretical value of noise, as noise density, in a frequency region up to 100 Hz, as illustrated in Fig. 14. Although this is not problematic in practice, the increase in noise density is however non-negligible in cases where high SN is required. This phenomenon of increased noise density is not observed in a case where an AC signal is obtained through application of DC bias to the acceleration sensors 100A, 100B, but has been found to be observable in cases where a low-frequency signal close to that of DC is obtained using AC bias.

### SUMMARY OF THE INVENTION

The source of this noise is the leakage current of the variable-capacitance diodes D1 and D2 that are used as variable-capacitance devices, and which cannot thus be used as they are in an AC bias method of high SN. This constitutes an unresolved problem.

Such being the case, is an object of the present invention, which focuses on solving the unresolved problems of the conventional examples described above, to provide an electric charge detection circuit that allows performing easily gain adjustment on the input side of a differential amplifier circuit, without using a variable-capacitance diode.

In a first aspect of the electric charge detection circuit according to the present invention, in order to attain the above goal, one end of a physical quantity detection sensor formed of any of an electric charge generation-type sensor and a capacitance change-type sensor is connected to a negative electrode input terminal of a differential amplifier circuit, and the other end is connected to a positive electrode input terminal of the differential amplifier circuit; a feedback resistor and a feedback capacitor are connected in parallel between the negative electrode input terminal and an output terminal of the differential amplifier circuit, and a cancel resistor and a cancel capacitor are connected in parallel between a reference voltage and the positive electrode input terminal of the differential amplifier circuit. A drain voltage adjustment circuit is provided that adjusts a drain voltage of at least one of two field effect transistors to which positive and negative differential inputs of the differential amplifier circuit are individually inputted, to enable gain adjustment of at least one of the positive and negative differential inputs.

In the above configuration, the drain voltage of at least one of two field effect transistors that make up a differential amplifier circuit is adjusted by a drain voltage adjustment circuit, to perform as a result gain adjustment of at least one of positive and negative differential inputs of the differential amplifier circuit. Accordingly, it becomes possible to curtail increases in noise density through accurate gain adjustment, also in cases where a low-frequency detection signal is obtained through application of AC bias to the physical quantity detection sensor.

In a second aspect of the electric charge detection circuit according to the present invention, the drain voltage adjustment circuit comprises a voltage control active element that is cascode-connected to the field effect transistor and that adjusts the drain voltage of the field effect transistor, and a DC voltage source that supplies DC voltage to the voltage control active element.

In this configuration, the drain voltage of the field effect transistor can be rendered variable by making variable the DC voltage that is supplied by the DC voltage source to the voltage control active element.

In a third aspect of the electric charge detection circuit according to the present invention, the voltage control active element in the drain voltage adjustment circuit is formed of a bipolar transistor that cascode-connects to the field effect transistor, such that the base of the bipolar transistor is connected to the output side of a differential amplifier, a positive electrode input terminal of the differential amplifier is connected to a DC voltage source, and the emitter side of the bipolar transistor is connected to a negative electrode side of the differential amplifier.

By way of the differential amplifier, this configuration allows canceling potential fluctuations between the base and emitter in the bipolar transistor.

In a fourth aspect of the electric charge detection circuit according to the present invention, a low pass filter is connected to the output side of the DC voltage source.

By way of the low pass filter, the above configuration allows suppressing fluctuation of DC voltage of the DC voltage source, and allows suppressing fluctuation of the drain voltage of the field effect transistor.

In a fifth aspect of the electric charge detection circuit according to the present invention, the drain voltage adjustment circuit uses a current mirror circuit in a load of the differential inputs, the drain voltage adjustment circuit that having a cascode-connected voltage control active element that adjusts the drain voltage of the field effect transistor that is connected to a reference current side of the current mirror circuit.

In a case where a current mirror circuit is used as a load, the above configuration allows adjusting the drain voltage of the field effect transistor, by way of a drain voltage adjustment circuit, on the reference current side of the current mirror circuit.

In a sixth aspect of the electric charge detection circuit according to the present invention, the drain voltage adjustment circuit uses a current mirror circuit in a load of the differential inputs, a negative electrode input terminal of a second differential amplifier is connected to the drain of a field effect transistor that is connected to a mirror current side of the current mirror circuit, and the voltage at the positive electrode input terminal of the second differential amplifier is controlled, thereby adjusting the drain voltage of the field effect transistor that is connected to the mirror current side.

By virtue of the above configuration, the voltage at the positive electrode input terminal is controlled through connection of the DC voltage source to the control side of the second differential amplifier, so that, as a result, the drain potential of the field effect transistor on the mirror current side and the potential of the DC voltage source are equalized, and the input capacitance of the field effect transistor on the mirror current side can be rendered variable by making variable the DC voltage source.

In the electric charge detection circuit of the present invention, thus, the drain voltage of at least one of two field effect transistors that make up a differential amplifier circuit is adjusted by a drain voltage adjustment circuit, in a case where a physical quantity detection sensor that comprises an electric charge generation-type sensor and a capacitance change-type sensor are driven with AC bias; as a result, this elicits the effect of making it possible to suppress increases in noise density through accurate adjustment of the input capacitance of at least one of positive and negative differential inputs.

### BRIEF DESCRIPTION OF THE DRAWINGS

Fig. 1 is a schematic diagram illustrating a differential amplifier circuit that is the basis of the present invention;
Fig. 2 is a block diagram illustrating a first embodiment of an electric charge detection circuit according to the present invention;
Fig. 3 is a characteristic diagram illustrating a relationship between source-drain voltage and input capacitance in a field effect transistor;
Fig. 4 is a characteristic diagram illustrating a relationship between DC voltage and output voltage on a positive electrode input side in Fig. 2;
Fig. 5 is a characteristic diagram illustrating a relationship between frequency and noise density in a case where no acceleration acts on a physical quantity detection sensor;
Fig. 6 is a circuit diagram of the electric charge detection circuit of Fig. 2, in which a differential amplifier circuit has been omitted;
Fig. 7 is a circuit diagram illustrating a conventional differential amplifier circuit;
Fig. 8 is a circuit diagram of an electric charge detection circuit illustrating a second embodiment of the present invention;
Fig. 9 is a circuit diagram of an electric charge detection circuit illustrating a third embodiment of the present invention;
Fig. 10 is a circuit diagram of an electric charge detection circuit illustrating a fourth embodiment of the present invention;
Fig. 11 is a circuit diagram illustrating an electric charge detection circuit in a conventional example;
Fig. 12 is a circuit diagram illustrating an electric charge detection circuit in which input capacitance is variable, in a conventional example;
Fig. 13 is a circuit diagram illustrating an electric charge detection circuit in a case where a conventional physical quantity sensor is AC-biased; and
Fig. 14 is a characteristic diagram illustrating a relationship between frequency and noise density in Fig. 13.

### DESCRIPTION OF THE PREFERRED EMBODIMENTS

Embodiments of the present invention are explained next with reference to accompanying drawings.

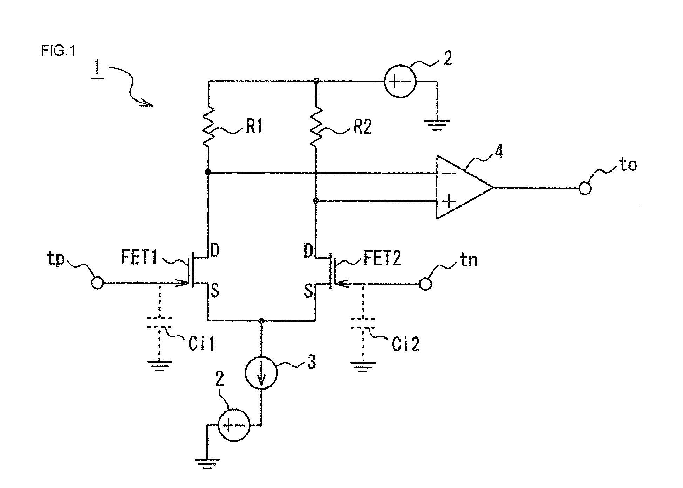

The basic configuration of a differential amplifier circuit that makes up an electric charge detection circuit will be explained firstly with reference to Fig. 1.

In an input stage of a differential amplifier circuit 1, a series circuit of a load resistor R1 and a junction-type field effect transistor FET 1 and a series circuit of a load resistor R2 and a junction-type field effect transistor FET 2 are connected in parallel to a positive electrode side of a DC voltage source 2, as illustrated in Fig. 1. The sources of both field effect transistors FET 1 and FET 2 are connected to each other, and are connected to the negative electrode side of the above-described DC voltage source 2 via a constant current circuit 3.

The gate of the field effect transistor FET 1 is connected to a positive electrode input terminal tp, and the gate of the field effect transistor FET 2 is connected to a negative electrode input terminal tn. Second- and subsequent-stage circuit sections represented in the form of a differential amplifier 4 are connected to a connection point of the load resistor R1 and the field effect transistor FET 1 and a connection point of the load resistor R2 and the field effect transistor FET 2. The output side of the differential amplifier 4 is connected to an output terminal to. Ordinarily, the second stage comprises an amplifier circuit, and the third stage comprises a buffer amplifier.

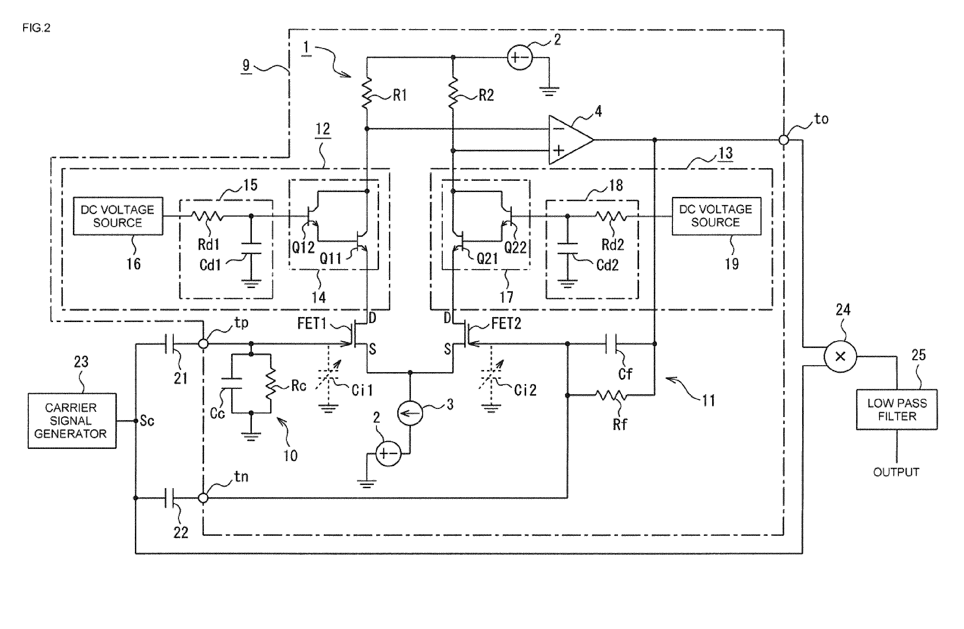

The output sides of a pair of acceleration sensors 21 and 22, which are capacitance change-type sensors as physical quantity detection sensors, are connected to the positive electrode input terminal tp and the negative electrode input terminal tn, as illustrated in Fig. 2 described below.

As explained above, supply of bias current is not allowed to the input terminals tp and tn in a charge amplifier as an electric charge detection circuit, in a physical quantity sensor, that measures small electrostatic capacitance. Therefore, MOS-type field effect transistors or junction-type field effect transistors, and not bipolar transistors, are used as the transistors that are connected to the input terminals tp and tn. Among the foregoing, MOS-type field effect transistors have substantial 1/f noise. Junction-type field effect transistors are thus used for high SN specifications. However, this does not mean that MOS-type field effect transistors cannot be used, and there is no mandatory limitation regarding the type of field effect transistor.

Input capacitances Ci1 and Ci2 are present in the field effect transistors FET 1 and FET 2 at the input stage illustrated in Fig. 1. These input capacitances Ci1 and Ci2 can be apparently regarded as grounded virtual capacitances, and hence are depicted with dotted lines in Fig. 1. The input capacitances Ci1 and Ci2 are capacitances in internal circuits, as viewed from the gates of the field effect transistors FET 1 and FET 2, and hence are each the sum of the gate-source capacitance and gate-drain capacitance of the respective field effect transistors FET 1 and FET 2.

When the sources of the field effect transistors FET 1 and FET 2 are viewed from the gates, a high density of majority carriers of the source region are present at a very close distance, and hence the greater part of the input capacitances Ci1 and Ci2 constitutes the capacitance herein. The density of majority carriers decreases as the carriers move gradually from the source towards the drain, and a depletion layer ostensibly spreads from a given point onwards. Focusing on this portion, the distance over which the depletion layer spreads up to the drain electrode varies depending on the voltage, in the same way as in a pn-junction at the time of application of reverse bias. Therefore, the input capacitances Ci1 and Ci2 can be adjusted by varying the drain voltage.

In the first embodiment of the present invention, therefore, an electric charge detection circuit 9 is configured, as illustrated in Fig. 2, with a view to modifying the drain voltages of the field effect transistors FET 1 and FET 2.

Specifically, the electric charge detection circuit 9 has the above-described differential amplifier circuit 1 illustrated in Fig. 1. A cancel circuit 10 in which a cancel resistor Rc and a cancel capacitor Cc are connected in parallel is connected between ground and a connection point between the gate of the field effect transistor FET 1 and the positive electrode input terminal tp of the differential amplifier circuit 1. A feedback circuit 11 in which a feedback resistor Rf and a feedback capacitor Cf are connected in parallel is connected between the negative electrode input terminal tn and the output side of the differential amplifier 4.

Drain voltage adjustment circuits 12 and 13 that adjust drain voltage are respectively interposed between the field effect transistors FET 1 and FET 2 and the load resistors R1 and R2 of the differential amplifier circuit 1.

The drain voltage adjustment circuit 12 comprises a voltage control active element 14 that is cascode-connected to the field effect transistor FET 1, between the field effect transistor and the load resistor R1, and a DC voltage source 16 the output voltage whereof can be adjusted arbitrarily and that is connected to the base of the voltage control active element 14 by way of a low pass filter 15. The voltage control active element 14 comprises Darlington-connected npn-type bipolar transistors Q11 and Q12.

The collector of the bipolar transistor Q11 is connected to the load resistor R1, and the emitter is connected to the drain of the field effect transistor FET 1. The collector of the bipolar transistor Q12 is connected between the load resistor R1 and the collector of the bipolar transistor Q11, the emitter is connected to the base of the bipolar transistor Q11, and the base is connected to the output side of the low pass filter 15.

The low pass filter 15 comprises a resistor Rd1 that is interposed between the DC voltage source 16 and the voltage control active element 14, and a capacitor Cd1 that is interposed between ground and a connection point of the resistor Rd1 and the voltage control active element 14.

Similarly to the drain voltage adjustment circuit 12, a drain voltage adjustment circuit 13 is provided with a voltage control active element 17 that is cascode-connected to the field effect transistor FET 2, a low pass filter 18, and a DC voltage source 19 the output voltage whereof can be adjusted arbitrarily. The voltage control active element 17 comprises Darlington-connected npn-type bipolar transistors Q21 and Q22.

The collector of the bipolar transistor Q21 is connected to the load resistor R2, and the emitter is connected to the drain of the field effect transistor FET 2. The collector of the bipolar transistor Q22 is connected between the load resistor R2 and the collector of the bipolar transistor Q21, the emitter is connected to the base of the bipolar transistor Q21, and the base is connected to the output side of the low pass filter 18.

The low pass filter 18 comprises a resistor Rd2 that is interposed between the DC voltage source 19 and the voltage control active element 17, and a capacitor Cd2 that is interposed between ground and a connection point of the resistor Rd2 and the voltage control active element 17.

One respective end of each of a pair of acceleration sensors 21 and 22, which are capacitance change-type sensors as physical quantity detection sensors, is connected to the positive electrode input terminal tp and the negative electrode input terminal tn, respectively, of the electric charge detection circuit 9. A carrier signal generator 23 that generates for instance a 50 kHz carrier signal Sc is connected to the other ends of the acceleration sensors 21 and 22. The variable-capacitances of the acceleration sensors 21 and 22 are sampled with the carrier signal Sc, and are supplied to the positive electrode input terminal tp and the negative electrode input terminal tn of the electric charge detection circuit 9.

The acceleration sensors 21 and 22 are capacitance change-type sensors in which a weight is held on a beam, a fixed electrode is held in the vicinity of side face of the weight, and acceleration is detected through measurement of the capacitance between the weight and the fixed electrode. Both acceleration sensors 21 and 22 measure a small electric charge (for instance, about 10 to 18 C). In the present embodiment, the acceleration sensors 21 and 22 are set to yield 1 G at 1 V.

The output terminal to of the electric charge detection circuit 9 is connected to one input side of a multiplier 24, and the carrier signal Sc that is outputted by the carrier signal generator 23 is inputted to the other input side of the multiplier 24.

The multiplier 24 is configured in such a manner that a low-frequency component of the acceleration signal, which is demodulated with the carrier signal Sc, passes through a low pass filter 25 having for instance a cutoff frequency of 1 kHz, to yield a low-frequency acceleration signal α of 1 kHz or less.

The operation of the first embodiment is explained next.

A 50 kHz carrier signal Sc is supplied to the acceleration sensors 21 and 22, acceleration components are sampled, and the in-phase signal noise of the sampled acceleration components is canceled in the cancel circuit 10 of the electric charge detection circuit 9. In the drain voltage adjustment circuit 12 and 13, the drain voltages of the field effect transistors FET 1 and FET 2 are adjusted, to adjust thereby the input capacitances Ci1 and Ci2; as a result, the positive and negative gains of the field effect transistors FET 1 and FET 2 can be made variable individually, and it becomes possible to increase the removal rate of in-phase signal noise.

Herein, the input capacitance of the differential amplifier circuit 1 is not adjusted using a variable-capacitance diode, as in the above-described conventional example, but is adjusted through adjustment of the drain voltages of the field effect transistors FET 1 and FET 2 that make up the differential amplifier circuit 1 in the drain voltage adjustment circuit 12 and 13. Therefore, it becomes possible to reliably suppress increases in noise density caused by leakage current in a variable-capacitance diode, as described above.

The drain voltage of the field effect transistor FET 1, to the gate whereof the positive electrode input terminal tp is connected, is determined by the emitter potential of the bipolar transistor Q11 that makes up the cascode-connected voltage control active element 14. The emitter potential is lower than the potential of the DC voltage source 16 by the pn-junction voltage (about 0.6 V). Therefore, the input capacitance Ci1 of the field effect transistor FET 1 can be adjusted through modification of the output voltage of the DC voltage source 16. That is, the input capacitance Ci1 decreases when the output voltage of the DC voltage source 16 is raised, and, conversely, the input capacitance Ci1 increases when the output voltage of the DC voltage source 16 is lowered.

Similarly, the input capacitance Ci2 of the field effect transistor FET 2, to the gate whereof the negative electrode input terminal tn is connected, can be adjusted by modifying the output voltage of the DC voltage source 19. That is, the input capacitance Ci2 decreases when the output voltage of the DC voltage source 19 is raised, and, conversely, the input capacitance Ci2 increases when the output voltage of the DC voltage source 16 is lowered.

Herein it is possible to achieve current gain since the bipolar transistor Q11, Q12 and Q21, Q22 in the voltage control active elements 14 and 17 are in Darlington connection. The output voltages of the DC voltage sources 16 and 19 can be reduced thus in proportion, and the influence of voltage fluctuation in the DC voltage sources 16 and 19 can be likewise reduced. Further, the low pass filters 15 and 18 are interposed between the DC voltage sources 16 and 19 and the voltage control active elements 14 and 17, and hence the influence of voltage fluctuation in the DC voltage sources 16 and 19 can be accordingly suppressed. In consequence, the input capacitances Ci1 and Ci2 can be accurately adjusted through accurate adjustment of the drain voltages of the field effect transistors FET 1 and FET 2.

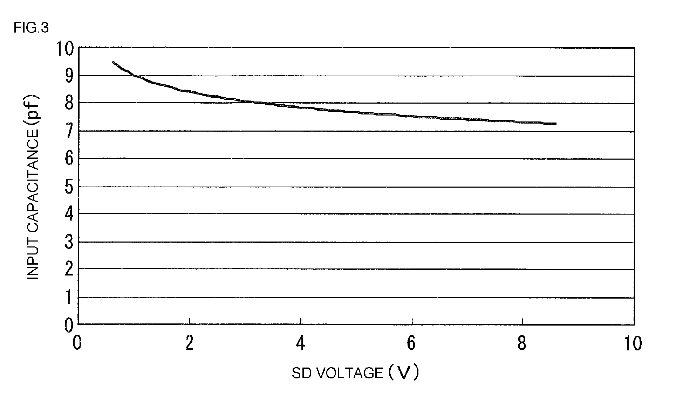

The relationship between the source-drain voltages of the field effect transistors FET 1 and FET 2 and the input capacitances Ci1 and Ci2 is such that the input capacitances Ci1 and Ci2 are 9.5 pF when the source-drain voltage V_{SD} is about 0.5 V, as illustrated in Fig. 3. Thereafter, the relationship obeys a characteristic represented by a quadratic curve in which the input capacitances Ci1 and Ci2 gradually decrease as the source-drain voltage V_{SD} increases. Electrostatic capacitance changes by 1 pF for a source-drain voltage V_{SD} from 1.5 V to 4 V. The amount of change of the electrostatic capacitance required in the electric charge detection circuit is 1 pF and satisfies this condition. If a larger variable capacitance were required, the variable range of the electrostatic capacitance could be widened by increasing total capacitance through connection of the voltage control active elements 14, 17 in parallel.

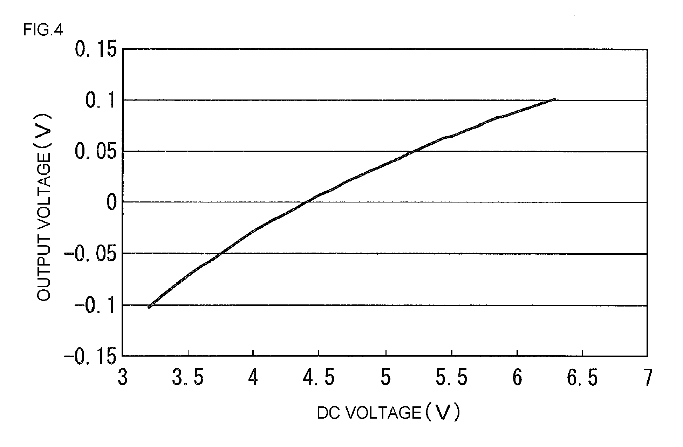

Fig. 4 illustrates the results of a DC measurement of a DC voltage Vd1 of the DC voltage source 16 and of the output voltage Vo that is outputted from the output terminal to, at a time where a DC voltage Vd2 of the DC voltage source 19 is fixed to, for instance, 4.6 V, and the DC voltage Vd1 is caused to vary within a range from about 3.25 V to 6.25 V. Herein, the acceleration sensor that is used as the above-described variable-capacitance sensor is set to yield 1 G at 1 V, and hence a change of ±0.1 V in the output voltage Vo corresponds to an adjustment of ±0.1 G. Thus, zero-offset adjustment of an acceleration sensor can be accomplished by modifying the removal rate of the in-phase signal.

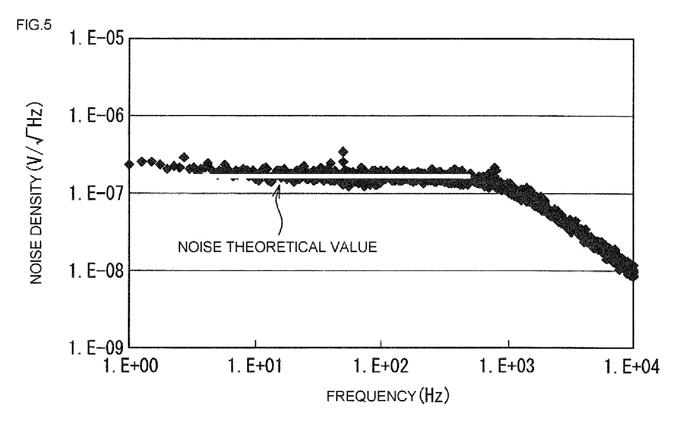

In the electric charge detection circuit 9 of the first embodiment, the relationship between the noise density with respect to the frequency in a state where no acceleration is imparted to the acceleration sensors 21 and 22 was such that the noise density becomes substantially identical to that of a theoretical value of noise in a low-frequency region where frequency is 100 Hz or less, as illustrated in Fig. 5, and it was thus possible to realize a low-noise electric charge detection circuit 9.

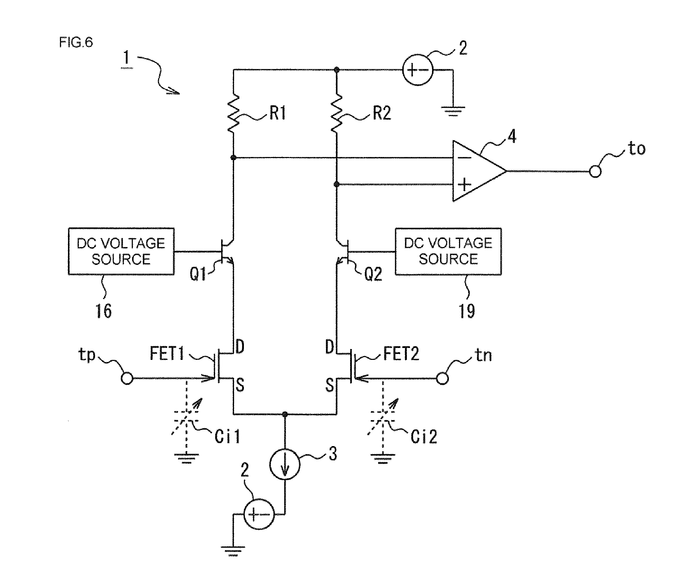

In the first embodiment, an instance has been explained where npn-type bipolar transistors in Darlington connection are used in the voltage control active elements 14 and 17, but the latter are not limited thereto, and may be configured each in the form of one npn-type bipolar transistor Q1 and Q2, as illustrated in Fig. 6.

In the first embodiment, an instance has been explained wherein npn-type bipolar transistors are used as the voltage control active elements 14 and 17, but the latter are not limited thereto, and similar effects can be elicited also by using n-channel junction-type field effect transistors instead of bipolar transistors.

In the first embodiment, an instance has been explained in which the output voltage of the DC voltage source 19 is fixed to 4.6 V, but the output voltage of the DC voltage source 19 can be fixed to any voltage, and in some cases the drain voltage adjustment circuit 13 can be omitted. The output voltage of the DC voltage source 19 is not limited to being fixed, and may be set to be variable.

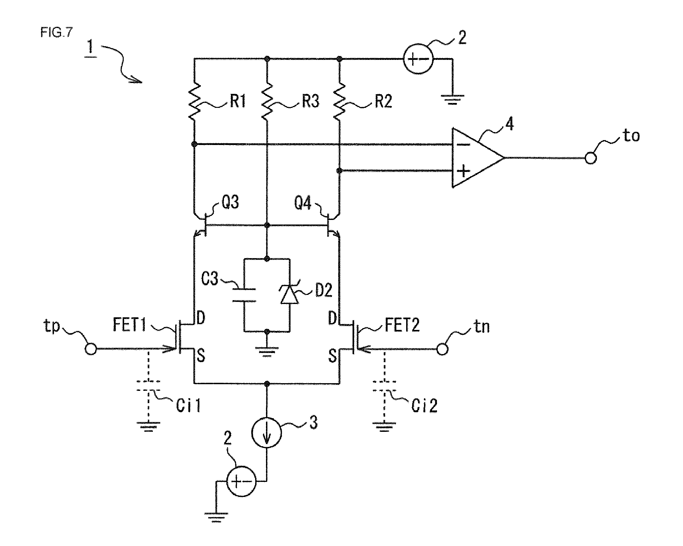

Differential amplifier circuits such as the one illustrated in Fig. 7 have been conventionally proposed in order to achieve low-noise and high-speed differential input. In this differential amplifier circuit, the bases of npn-type bipolar transistors Q3 and Q4, which make up the drain voltage adjustment circuits 12 and 13 and are interposed between the load resistors R1 and R2 and the field effect transistors FET 1 and FET 2, are connected to each other, and the midpoint between the bases of the bipolar transistors Q3 and Q4 is connected to the positive electrode side of the DC voltage source 2 via a resistor R3. The differential amplifier circuit has a configuration in which the circuit is connected to ground by way of a parallel circuit of a constant current diode Dz and a capacitor C3, and is cascode-connected through overlap of the bipolar transistors Q3 and Q4.

In this conventional example, ordinarily, a so-called mirror effect is elicited in the field effect transistors FET 1 and FET 2 at the input stage whereby when an input voltage that is inputted to the gates rises by ΔVi, the feedback capacitance between drain and gate becomes a gain multiple with a drop of GΔVi, where G is the gain of the drain voltage V_{D}. The initial response speed is determined by the gain-multiple feedback capacitance and load resistors R1 and R2.

Accordingly, cascode connection through overlapping of the bipolar transistors Q3 and Q4 is resorted to in order to achieve low noise and high-speed differential input in a twostage configuration of an input stage and a feedback capacitance stage.

That is, the mirror effect can be reduced at the connection point between the load resistors R1 and R2, at which gain is generated, if in order to obtain a characteristic such that resistance is as low as possible (low noise), the field effect transistors FET 1 and FET 2 that constitute the input stage transistors are configured as having a large surface area (large capacitance) and, with a view to preventing the mirror effect, the drain potentials of the field effect transistors FET 1 and FET 2 are fixed at the emitter potential of the bipolar transistors Q3 and Q4, and the bipolar transistors Q3 and Q4 are configured in the form of low-capacitance transistors. Preferably, the emitter potentials of the two bipolar transistors Q3 and Q4 are identical, since a differential characteristic is required.

In the conventional example of Fig. 7, thus, the drain potentials of the two field effect transistors FET 1 and FET 2 are fixed at one potential, and hence the drain voltages of the field effect transistors FET 1 and FET 2 cannot be individually adjusted independently, as in the first embodiment of the present invention described above. Although the configurations are thus seemingly similar the effects afforded by the two configurations are however wholly dissimilar, and the effect elicited in the first embodiment of the present invention cannot be achieved in the conventional example of Fig. 7.

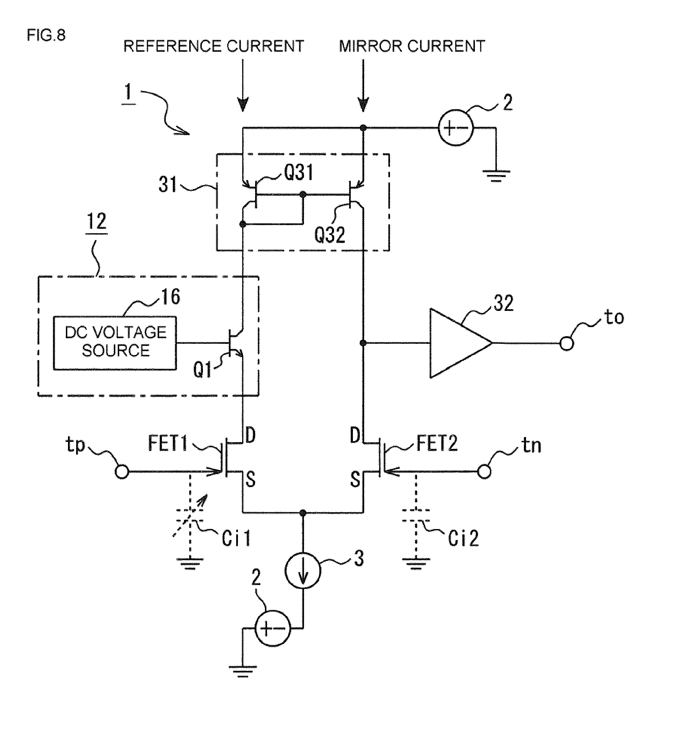

A second embodiment of the present invention is explained next with reference to Fig. 8.

In the second embodiment, the load resistors R1 and R2 have been omitted, and the current mirror circuit constitutes a load.

In the second embodiment, the load resistors R1 and R2 that are the initial stage of the differential amplifier circuit 1 in the configuration of Fig. 2 of the first embodiment described above have been omitted, as illustrated in Fig. 8, and a current mirror circuit 31 is connected, as a load, instead of the load resistors R1 and R2. The current mirror circuit 31 has pnp-type bipolar transistors Q31 and Q32 the emitters whereof are connected to the positive electrode side of the DC voltage source 2, and has a configuration wherein the bases of both bipolar transistors Q31 and Q32 are connected to each other, and the midpoint between bases is connected to the collector of the bipolar transistor Q31.

A drain voltage adjustment circuit 12 identical to that of the first embodiment described above is provided between the field effect transistor FET 1 and the bipolar transistor Q31 that constitutes the reference current side of the current mirror circuit 31. The drain voltage adjustment circuit 13 between the field effect transistor FET 2 and the bipolar transistor Q32 that constitutes the mirror current side is omitted. The connection point between the bipolar transistor Q32 and the field effect transistor FET 2 is connected to an amplifier 32, and the output side of the amplifier 32 is connected to the output terminal to.

In the second embodiment, current flowing in the bipolar transistor Q31 on the reference current side is caused, by the current mirror circuit 31, to flow to the bipolar transistor Q32 on the mirror current side.

The input capacitance Ci1 can be modified herein through adjustment of the drain voltage of the field effect transistor FET 1 by the drain voltage adjustment circuit 12, on the reference current side. On the mirror current side, the drain voltage adjustment circuit 13 that adjusts the drain voltage of the field effect transistor FET 2 is omitted, and hence the input capacitance Ci2 of the field effect transistor FET 2 is fixed. Therefore, an effect identical to that of the first embodiment described above can be elicited herein as well.

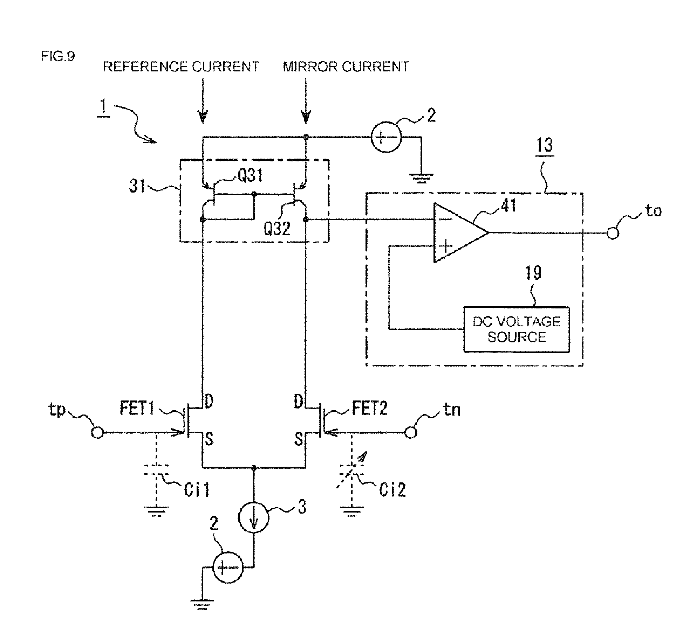

A third embodiment of the present invention is explained next with reference to Fig. 9.

In the third embodiment there is modified the input capacitance of a field effect transistor on the mirror current side, in a case where a current mirror circuit is used as a load.

In the third embodiment, specifically, the drain voltage adjustment circuit 12 in the configuration of Fig. 8 described above is omitted; instead, the drain voltage adjustment circuit 13 is provided on the mirror current side of the current mirror circuit 31, as illustrated in Fig. 9.

The drain voltage adjustment circuit 13 has a configuration wherein the connection point between the bipolar transistor Q32 and the field effect transistor FET 2 is connected to a negative electrode input terminal of a differential amplifier 41 that comprises an operational amplifier, the DC voltage source 19 is connected to the positive electrode input terminal of the differential amplifier 41, and the output side of the differential amplifier 41 is connected to the output terminal to. The negative electrode input terminal tn is connected to the gate of the field effect transistor FET 1, and the positive electrode input terminal Tp is connected to the gate of the field effect transistor FET 2.

In the third embodiment, the drain voltage adjustment circuit 12 of the field effect transistor FET 1 on the reference current side of the current mirror circuit 31 is omitted, and hence the drain voltage of the field effect transistor FET 1 is fixed, and the input capacitance Ci1 of the field effect transistor FET 1 is correspondingly fixed.

The drain voltage adjustment circuit 13 is provided on the mirror current side of the current mirror circuit 31. In the drain voltage adjustment circuit 13, a point between the drain of the field effect transistor FET 2 and the collector of the bipolar transistor Q32 of the current mirror circuit 31 is connected to the negative electrode input terminal of the differential amplifier 41, and the DC voltage source 19 is connected to the positive electrode input terminal of the differential amplifier 41. Therefore, the drain potential of the field effect transistor FET 2 and the potential of the DC voltage source 19 are equalized. Thus, making variable the DC voltage outputted by the DC voltage source 19 allows modifying the input capacitance Ci2 of the field effect transistor FET 2 through modification of the drain voltage of the field effect transistor FET 2, and an effect identical to that of the first and the second embodiments described above can be elicited herein as well.

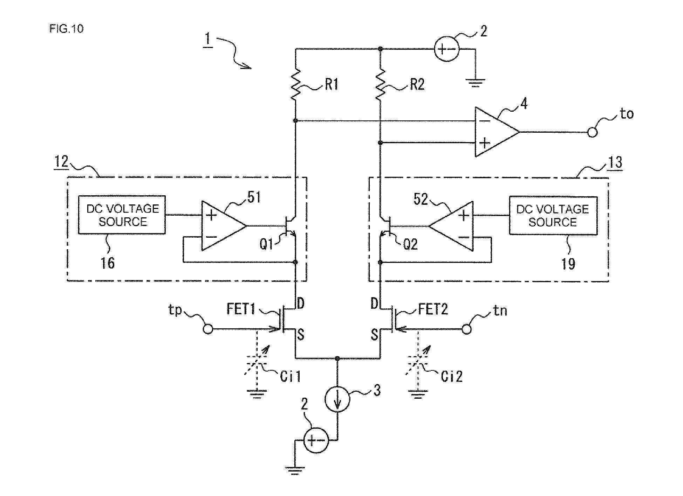

A fourth embodiment of the present invention is explained next with reference to Fig. 10.

In the fourth embodiment, there is prevented potential fluctuation between the base and emitter of a bipolar transistor that is cascode-connected to the field effect transistor that makes up the input stage of a differential amplifier circuit.

As illustrated in Fig. 10, in the fourth embodiment, the output sides of differential amplifiers 51 and 52 that are made up of operational amplifiers are connected to the bases of the bipolar transistors Q1 and Q2 that are cascode-connected to the field effect transistors FET 1 and FET 2, in the configuration of Fig. 6 of the first embodiment.

The DC voltage source 16 is connected to the positive electrode input terminal of the differential amplifier 51, and the emitter side of the bipolar transistor Q1 is connected to the negative electrode input terminal.

The DC voltage source 19 is connected to the positive electrode input terminal of the differential amplifier 52, and the emitter side of the bipolar transistor Q2 is connected to the negative electrode input terminal.

In the fourth embodiment, the emitters of the bipolar transistors Q1 and Q2 that are cascode-connected to the field effect transistors FET 1 and FET 2 are connected to the negative electrode input terminals of the differential amplifiers 51 and 52 the output sides whereof are connected to the bases of the bipolar transistors Q1 and Q2. Therefore, potential fluctuations between the bases and emitters of both bipolar transistors Q1 and Q2 can be canceled, and the drain voltages of the field effect transistors FET 1 and FET 2 can be adjusted stably.

In the fourth embodiment as well, n-channel junction-type field effect transistors can be used instead of the npn-type bipolar transistors Q1 and Q2.

In the first to fourth embodiments, an instance has been explained wherein the present invention is applied to a capacitance change-type sensor, but the invention is not limited thereto, and the electric charge detection circuit 9 of the present invention may be used in an electric charge generation-type sensor such as a pressure sensor, a microphone, an acceleration sensor, an angular velocity sensor, a strain gauge or the like, which utilize a piezoelectric element of an insulator. In this case, it is sufficient to adjust the input capacitance of at least one from among the field effect transistors FET 1 and FET 2, by adopting a configuration identical to those of the first to fourth embodiments described above, except for the feature whereby one end of the electric charge generation-type sensor is connected to the positive electrode input terminal tp, and the other end is connected to the negative electrode input terminal tn.

In the present invention, the drain voltage of at least one of two field effect transistors that make up a differential amplifier circuit is adjusted by a drain voltage adjustment circuit, in a case where a physical quantity detection sensor that comprises an electric charge generation-type sensor and a capacitance change-type sensor is driven with AC bias. Accordingly, it becomes possible to suppress increases in noise density through accurate adjustment of the input capacitance of at least one of positive and negative differential inputs.

### EXPLANATION OF REFERENCE NUMERALS

- 1: differential amplifier circuit
- 2: DC voltage source
- 3: constant current circuit
- R1,: R2 load resistance
- FET 1, FET 2: field effect transistor
- 4: differential amplifier
- tp: positive electrode input terminal
- tn: negative electrode input terminal
- to: output terminal
- 9: electric charge detection circuit
- 10: cancel circuit, 11... feedback circuit
- 12, 13: drain voltage adjustment circuit
- 14, 17: voltage control active element
- 15, 18: low pass filter
- 16, 19: DC voltage source
- 21, 22: acceleration sensor
- 23: carrier signal generator
- 24: multiplier
- 25: low pass filter
- 31: current mirror circuit
- Q31, Q32: bipolar transistor
- 32: amplifier
- 41: differential amplifier
- 51, 52: differential amplifier

## Claims

1. An electric charge detection circuit, configured such that one end of a physical quantity detection sensor formed of any of an electric charge generation-type sensor and a capacitance change-type sensor is connected to a negative electrode input terminal of a differential amplifier circuit, and the other end is connected to a positive electrode input terminal of the differential amplifier circuit;
a feedback resistor and a feedback capacitor are connected in parallel between the negative electrode input terminal and an output terminal of the differential amplifier circuit, and a cancel resistor and a cancel capacitor are connected in parallel between a reference voltage and the positive electrode input terminal of the differential amplifier circuit;
a drain voltage adjustment circuit is provided that adjusts a drain voltage of at least one of two field effect transistors, to which positive and negative differential inputs of the differential amplifier circuit are individually inputted, to enable gain adjustment of at least one of the positive and negative differential inputs.

2. The electric charge detection circuit according to claim 1, wherein the drain voltage adjustment circuit formed of a voltage control active element that is cascode-connected to the field effect transistor and that adjusts the drain voltage of the field effect transistor, and a DC voltage source that supplies DC voltage to the voltage control active element.

3. The electric charge detection circuit according to claim 2, wherein the voltage control active element in the drain voltage adjustment circuit comprises a bipolar transistor that cascode-connects to the field effect transistor, such that a base of the bipolar transistor is connected to an output side of a differential amplifier, a DC voltage source is connected to a positive electrode input terminal of the differential amplifier, and the emitter side of the bipolar transistor is connected to a negative electrode side of the differential amplifier.

4. The electric charge detection circuit according to claim 2 or 3, wherein a low pass filter is connected to the output side of the DC voltage source.

5. The electric charge detection circuit according to claim 1, wherein the drain voltage adjustment circuit uses a current mirror circuit in a load of the differential inputs,
the drain voltage adjustment circuit having a cascode-connected voltage control active element that adjusts the drain voltage of the field effect transistor that is connected to a reference current side of the current mirror circuit.

6. The electric charge detection circuit according to claim 1, wherein the drain voltage adjustment circuit uses a current mirror circuit in a load of the differential inputs, a negative electrode input terminal of a second differential amplifier is connected to the drain of a field effect transistor that is connected to a mirror current side of the current mirror circuit, and the voltage at the positive electrode input terminal of the second differential amplifier is controlled, thereby adjusting the drain voltage of the field effect transistor that is connected to the mirror current side.
